# EUROPEAN PATENT APPLICATION

(11) **EP 4 765 206 A1**
(43) Date of publication of application: **24.06.2026**
(21) Application number: 24220477.4
(22) Date of filing: 17.12.2024
(51) Int. Cl.: H01L 25/07, H01L 23/538, H02M 7/00

(54) **A T-TYPE NEUTRAL POINT CLAMP POWER MODULE WITH DOUBLE SIDED COOLING**

(71) Applicant: Volvo Car Corporation, 405 31 Göteborg (SE)
(72) Inventor: Zhang, Chi, SE-405 31 Göteborg (SE)
(74) Representative: Nederlandsch Octrooibureau

(57) **Abstract**

A power module comprises a positive direct current terminal (DCP), a negative direct current terminal (DCN), a neutral terminal (N) and an alternating current terminal (AC). The positive direct current terminal (DCP) is connected to the alternating current terminal (AC) via a first switching element (S1). The neutral terminal (N) is connected to the alternating current terminal (AC) via a third switching element (S3) and a second switching element (S2). The negative direct current terminal (DCN) is connected to the alternating current terminal (AC) via a fourth switching element (S4). The power module further comprises a top substrate (311) and a bottom substrate (312) facing the top substrate (311). At least one of the switching elements (S1, S2, S3, S4) is fixed to the top substrate (311) and at least one of the switching elements (S1, S2, S3, S4) is fixed to the bottom substrate (312).

## Description

### Technical Field

The present disclosure relates to a power module.

### Background of the Present Disclosure

A T-type inverter is a three-level inverter, which means it can produce three different voltage levels at its output: positive, zero, and negative. The main components of a T-type inverter include switches (IGBTs or MOSFETs) used to control the flow of current, diodes that provide paths for the current when the switches are off, and capacitors that stabilize the voltage levels.

In operation, the T-type inverter can produce a positive output voltage when the top switch (S1) is on and the middle switch (S2) is off, connecting the output to the positive DC bus. A zero output voltage is achieved when the middle switch (S2) is on, connecting the output to the neutral point. A negative output voltage occurs when the bottom switch (S3) is on and the middle switch (S2) is off, connecting the output to the negative DC bus. The switches are controlled in a specific sequence to generate the desired output waveform, ensuring that the voltage stress on each switch is only half of the DC bus voltage, which is a significant advantage over traditional two-level inverters.

The T-type inverter offers several advantages, including reduced voltage stress on each switch, improved efficiency due to lower switching losses and better thermal management, and better output quality with a cleaner waveform and lower harmonic distortion. These inverters are commonly used in renewable energy systems, such as solar inverters, motor drives for industrial and electric vehicle applications, and uninterruptible power supplies (UPS) to ensure a stable power supply. However, the T-type inverter is not limited to these applications.

The 3L-TNPC (Three-Level T-Type Neutral Point Clamped) inverter is known to be used in electrified propulsion applications because of to its efficiency, relatively low total harmonic distortion (THD), and relatively low common mode noise. Such 3L-TNPC is known to comprise wide bandgap (WBG) devices. However, the benefits of these devices are limited by their switching rate and overheating. The introduction of an extra neutral leg complicates the commutation loop. Unbalanced commutation loops may lead to undesirable stray inductance.

The background section is merely intended to provide a contextual overview of some current issues and is not intended to be exhaustive. Other contextual information may become apparent to a person of skill in the art upon review of the following detailed description.

### Summary of the Present Disclosure

According to an aspect, a power module may be provided, comprising:
a positive direct current terminal, a negative direct current terminal, a neutral terminal and an alternating current terminal, wherein
the positive direct current terminal is connected to the alternating current terminal via a first switching element,
the neutral terminal is connected to the alternating current terminal via a third switching element and a second switching element, and
the negative direct current terminal is connected to the alternating current terminal via a fourth switching element;
wherein the power module further comprises a top substrate and a bottom substrate facing the top substrate, and wherein at least one of the switching elements is fixed to the top substrate and at least one of the switching elements is fixed to the bottom substrate.

The separate top substrate and bottom substrate allow to cool each side in parallel, so that the component may be more efficiently kept in the desired temperature range. Moreover, by fixing at least one switching element to the top substrate and at least one switching element to the bottom substrate, the heat dissipation of the switches is divided over the two substrates, allowing them to be more efficiently cooled.

The inventors have realized that planar type concepts (with the components in a planar layout) can be optimized to either reduce stray inductance or thermal resistance. It is difficult to reduce both simultaneously with planar solutions. This invention proposes a vertical solution forming a three-dimensional layout, with the components distributed on several substrates, which allows to reduce both stray inductance and thermal resistance.

The power module may further comprise a top secondary substrate fixed to the top substrate and a bottom secondary substrate fixed to the bottom substrate, wherein the top secondary substrate and the bottom secondary substrate are in between the top substrate and the bottom substrate. This facilitates to provide a conductive layer in between the respective substrate and secondary substrate.

The second switching element may be fixed to the top secondary substrate, wherein the top secondary substrate is in between the top substrate and the second switching element. Thus, a conductive layer can pass in between the top substrate and the top secondary substrate, without contacting the second switching element.

Likewise, the third switching element may be fixed to the bottom secondary substrate, wherein the bottom secondary substrate is in between the third switching element and the bottom substrate. This way, a conductive layer can pass in between the bottom substrate and the top secondary substrate, without contacting the third switching element.

The top substrate and the bottom substrate may each comprise two electrically conductive surfaces with an electrically isolating layer in between, and the top secondary substrate and the bottom secondary substrate may also each comprise two electrically conductive surfaces with an electrically isolating layer in between. This way, the electrically conductive layer in between the substrates may be formed by the conductive surfaces of the substrates. On the outside of the power module, the electrically conductive surfaces of the primary and secondary substrates may also provide for thermal conductivity. Moreover, on the inside of the power module the electrically conductive surfaces may be used to electrically connect the components such as switches that are fixed to the substrate. Electric paths may be carved in the electrically conductive surfaces.

The second switching element may be fixed to the top secondary substrate, wherein the top secondary substrate may be in between the second switching element and the top substrate, and the third switching element may be fixed to the bottom secondary substrate, wherein the bottom secondary substrate may be in between the third switching element and the bottom substrate. This way the heat dissipation is divided over the substrates on both sides of the power module. Moreover, separate electrically conductive paths are generated that pass along these switching elements without being electrically connected to these switching elements.

The power module may further comprise a first supportive conductive element connecting the top substrate to the bottom substrate and/or a second supportive conductive element connecting the top secondary substrate to the bottom secondary substrate. Such a supportive conductive element provides sufficient volume inside the power module, avoiding collapse thereof, while providing an electric connection between the mutually facing conducting surfaces of the top substrate and the bottom substrate or between the mutually facing conductive surfaces of the top secondary substrate and the bottom secondary substrate.

A drain side of a first switching element may be fixed to the conductive surface of the top substrate, a drain side of the second switching element may be fixed to the conductive surface of the top secondary substrate, a drain side of the third switching element may be fixed to the conductive surface of the bottom secondary substrate, and a drain side of the fourth switching element may be fixed to the conductive surface of the bottom substrate. Herin fixed means fixedly attached to, and also electrically connected to. This may provide the desired heat dissipation into the substrates while providing a desired flow of electric current.

A source of the first switching element may be electrically conductively connected to the conductive surface of the top substrate, a source of the second switching element may be electrically conductively connected to the conductive surface of the top secondary substrate, a source of the third switching element may be electrically conductively connected to the conductive surface of the bottom secondary substrate, and a source of the fourth switching element may be electrically conductively connected to the conductive surface of the bottom substrate. Moreover, the respective conductive surface may be interrupted in between the respective drain side and connection to the source of the same switching element, so that the drain and the source of the same switching element are not connected to each other via the conductive surface. This may allow for an efficient organization of the switches. Moreover, it may facilitate the provision of an advantageous commutation loop.

The first switching element may face the fourth switching element and the second switching element may face the third switching element. This may allow for an efficient organization of the switches. Moreover, it may facilitate the provision of an advantageous commutation loop.

The power module may comprise a first supportive conductive element connecting the top substrate to the bottom substrate. The second switching element may be fixed in between the first switching element and the first supportive conductive element. The third switching element may be fixed in between the fourth switching element and the first supportive conductive element. This may allow for an efficient organization of the switches. Moreover, it may facilitate the provision of an advantageous commutation loop.

The first switching element, the second switching element, the third switching element, and the fourth switching element may each comprise a power semiconductor switch. The power semiconductor switch is an advantageous implementation of a switching element of a power module.

The power module may further comprise a first cooling element adjacent a surface of the top substrate facing away from the bottom substrate; and a second cooling element adjacent a surface of the bottom substrate facing away from the top substrate. This allows to cool the power module efficiently from both sides.

The person skilled in the art will understand that the features described above may be combined in any way deemed useful.

### Brief Description of the Drawings

The present disclosure will be described in further detail hereinafter with reference to the drawings. Similar items may be indicated by the same reference numerals throughout the drawings. The drawings are diagrammatic and may not be drawn to scale.
FIG. 1 shows a diagram of a 3L-TNPC inverter.
FIG. 2 shows a sketch of a layout of a printed circuit of a 3L-TNPC inverter.
FIG. 3 shows a section view of a 3L-TNPC inverter package.
FIG. 4 shows an exploded view of the 3L-TNPC inverter package of FIG. 3.
FIG. 5 illustrates aspects of the inverter package and an assembly process thereof.
FIG. 6 illustrates performance aspects of 3L-TNPC inverters.

### Detailed Description

Certain exemplary embodiments will be described in greater detail, with reference to the accompanying drawings. The matters disclosed in the description, such as detailed construction and elements, are provided to assist in a comprehensive understanding of the exemplary embodiments. Accordingly, it is apparent that the exemplary embodiments can be carried out without those specifically defined matters. Also, well-known operations or structures are not described in detail, since they would obscure the description with unnecessary detail.

Although for the sake of clarity in the present disclosure, reference is made to different components as "top" or "bottom" elements, it will be understood that these concepts are used to indicate two opposite sides of the power module. Moreover, it will be understood that these concepts are exchangeable. That is, since the power module can be rotated and assembled in any desired orientation, the "top" elements can be below or beside the "bottom" elements depending on the current orientation of the power module.

The 3L-TNPC (Three-Level T-Type Neutral Point Clamped) inverter is widely used in electrified propulsion applications due to its efficiency, low total harmonic distortion (THD), and low common mode noise. However, fully exploiting the advantages of wide bandgap (WBG) devices remains challenging. Fast switching speeds lead to the desire for a low stray inductance (L_{stray}) design solution for the power loop and a robust, intelligent gate driver design that can optimize slew rate, overshoot, and switching loss simultaneously. Additionally, the small size of WBG device bare dies makes it desirable to provide a power module with lower thermal resistance.

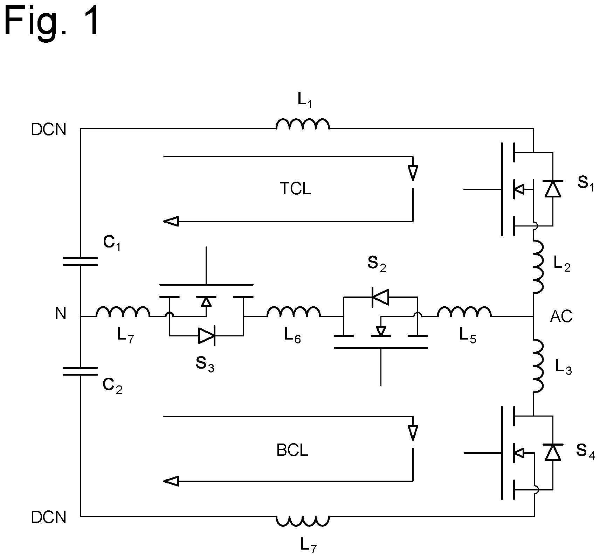

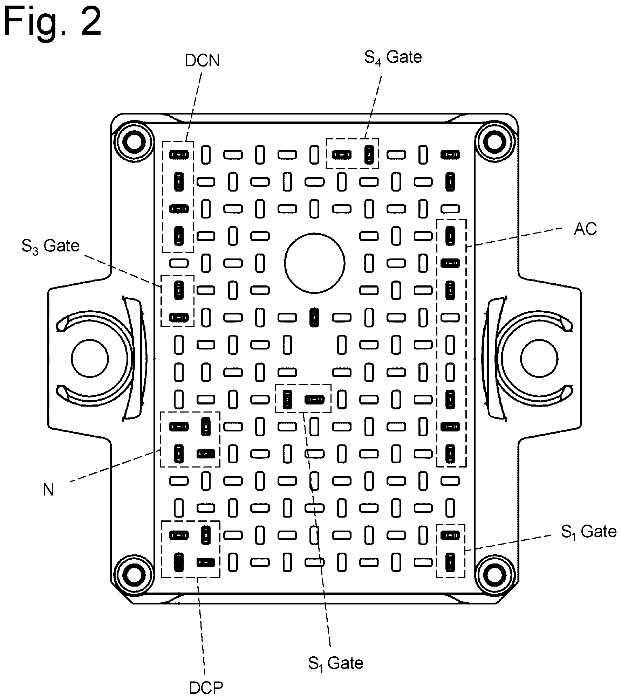

FIG. 1 shows a diagram of a 3L-TNPC inverter, including positive direct current terminal DCP, a negative direct current terminal DCN, a neutral terminal N, an alternating current terminal AC, and switches S1 through S4. The 3L-TNPC inverter has demonstrated high efficiency, lower THD, and reduced electromagnetic interference (EMI), in e.g. applications ranging from 400VDC to 1.2KVDC. The introduction of an extra neutral leg (S2 and S3) complicates the commutation loop, resulting in a more complex Top Commutation Loop (TCL) and Bottom Commutation Loop (BCL), as shown in FIG. 1. A typical easy-pack based TNPC package with the same switches and terminals, illustrated in FIG. 2, reveals that switches S1-S4 are arranged asymmetrically, leading to unbalanced TCL and BCL. In high power applications, this asymmetry has been shown to cause a 6nH difference in stray inductance (Lstray).

An aspect of the present disclosure is to provide a package design for a 1.2kV/300A 3L-TNPC inverter, with a vertical structure. This vertical structure may have one or both of the following advantages. First, the unbalanced stray inductance between TCL and BCL may be reduced. Second, double-sided cooling may be enabled, with lower power module thermal resistance.

An aspect of the present disclosure is to provide a package design with balanced stray inductance between the two current commutation loops (TCL and BCL). Further, in certain embodiments, stray inductance in both commutation loops may be reduced to less than 4nH. In certain embodiments, reduction of thermal resistance of the power module to 0.2K/W is possible. In certain embodiments, smaller stray inductance and thermal resistance may be achieved simultaneously.

The power module disclosed herein may be suitable for both SiC (Silicon Carbide) and GaN (Gallium Nitride) based devices. However, this is not a limitation. Other kinds of devices may be used as components of the power module.

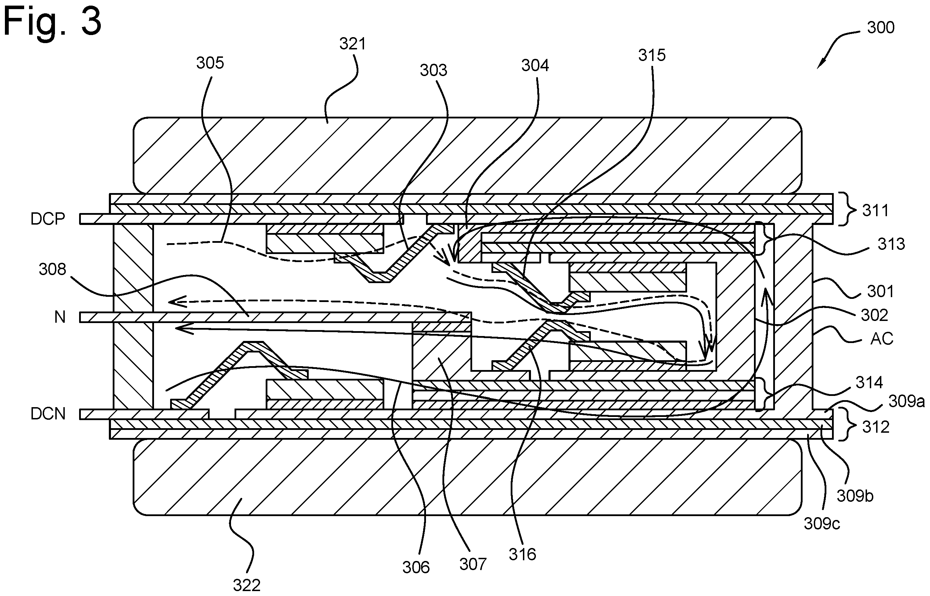

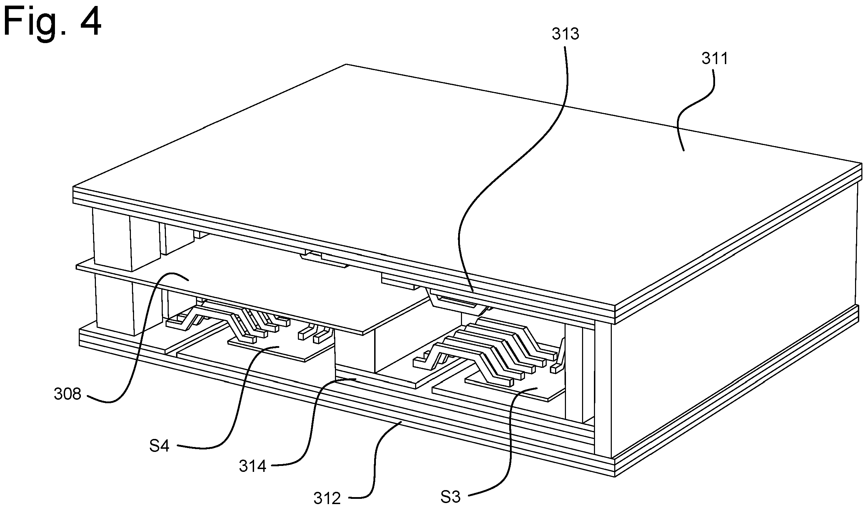

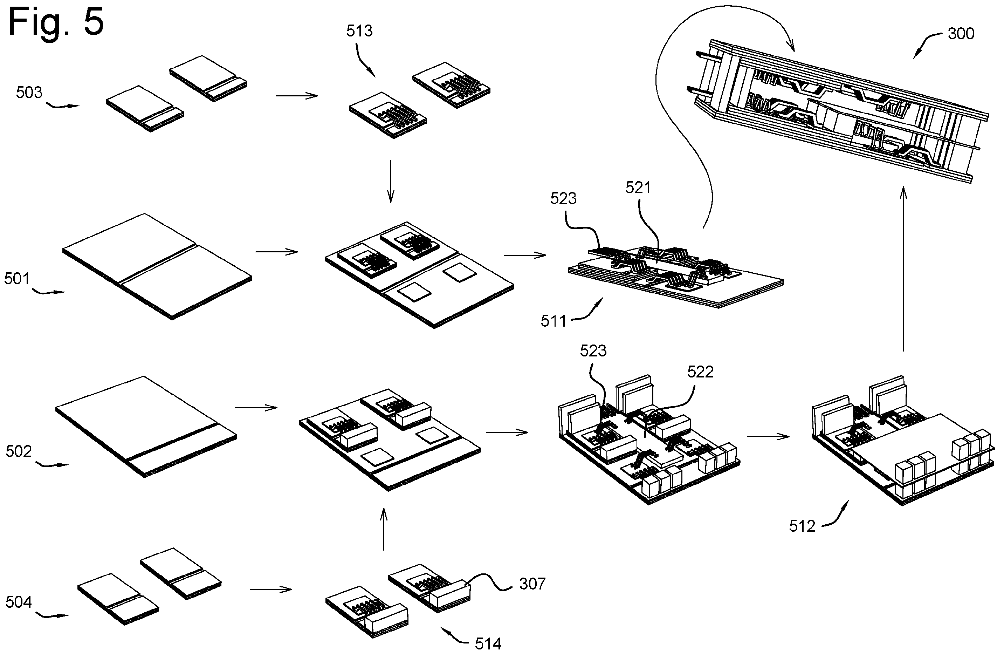

FIG. 3 shows a section view of a molded package. FIG. 4 shows an exploded perspective view of this package. Switches S1 and S2 are located on the top side, while switches S3 and S4 are on the bottom side. A secondary substrate is used for switches S2 and S3. One copper post 301 is used to implement the AC connection, while the other copper post 302 achieves a drain connection between switches S2 and S3. These two copper posts also serve as mechanical support inside the package. Instead of copper, any suitable material may be selected as a conductive support element. The support element may be configured to keep the top and bottom (secondary) substates at a fixed distance of each other. The post may be made of a material that provides sufficient support and electric conductivity. Alternatively, the post may be made of a supporting electrically non-conductive material, with addition to an electrically conductive path by means of e.g. a conductive coating of the post, or an electrically conductive wire. For example, a bonding wire or a copper clip can be used for the interconnection of different bare dies. Decoupling capacitors (C1 and C2) are placed between the terminals DCP, N, and DCN to provide a path for high-frequency current commutation. These decoupling capacitors C1 and C2 may be provided with packages, such as 1210 packages. To increase current capability, two SiC bare dies may be connected in parallel, as shown in FIG. 5.

As best seen in FIG. 5, two gate interface boards 521 and 522 are inserted on both the top and bottom sides to provide access to the gates of the switches S1, S2, S3, S4 via respective gate terminals 523. The gate and source of the SiC bare dies are electrically connected to the circuitry using bonding wires 303. The commutation loops 305 and 306 are shown in FIG. 3. The curved arrow 305 indicates the Top Commutation Loop (TCL), and the curved arrow 306 indicates the Bottom Commutation Loop (BCL). It can be seen that two symmetrical commutation loops are achieved. The commutation loops have overlapping position and opposite direction, so that they may partially or completely cancel out each other's undesired inductive effects.

As shown in FIG. 3, two cooling elements 321, 322 may be arranged so that there is a cooling element on both sides of the package 300. Thus, a first cooling element 321 may be provided adjacent a surface of the top substrate 311, said surface facing away from the bottom substrate 312, and a second cooling element 322 may be provided adjacent a surface of the bottom substrate 312, said surface facing away from the top substrate 311. This way the heat dissipated by the power unit can be efficiently removed. The cooling elements may be implemented, for example, as a container fluidly connected in a circuit with a heat exchanger so that by flowing a coolant through the container the package 300 is cooled. Other kinds of cooling element, such as passive cooler such as fins cooled by airflow, are also envisaged.

FIG. 5 illustrates aspects of a possible assembly process. In the example assembly process, a package with two identical parallel circuits is generated side by side. However, this is not a limitation. A package with a single circuit is possible. Similarly, a package with any desired number of parallel circuits can be manufactured by extending the teachings disclosed herein. In a parallel circuit, the corresponding terminals of each circuit can be electrically connected to each other to combine the power of all circuits in one set of terminals DCP, N, DCN, and AC.

Column 503 illustrates steps in preparation of the top secondary part 511. In step 1 the top secondary substrate 313 is prepared, by carving the desired electrical paths in the conductive layer(s) of the substrate 313. In step 2, the switch S2 is molded on the surface, with the drain, and source electrically connected to one electrical surface layer of the top secondary substrate 313, wherein the drain is electrically isolated from the gate and source. In certain embodiments, the drain side is electrically connected and molded onto the electrically conductive surface layer of the top secondary substrate, and the source is electrically connected to the electrically conductive surface layer of the top secondary substrate 313 via a bonding wire 315. However, other connection configurations are possible.

Column 504 illustrates steps in preparation of the bottom secondary part 514. In step 1 the bottom secondary substrate 314 is prepared, by carving the desired electrical paths in the conductive layer(s) of the substrate 314. In step 2, the switch S3 is molded on the surface, with the drain, and source electrically connected to one electrical surface layer of the bottom secondary substrate 314, wherein the drain is electrically isolated from the gate and source. In certain embodiments, the drain side is electrically connected and molded onto the electrically conductive surface layer of the bottom secondary substrate 314, and the source is electrically connected to the electrically conductive surface layer of the bottom secondary substrate 314 via a bonding wire 316. However, other connection configurations are possible. Further, in step 2, a pillar 307 is attached to support a further substrate 308, referred to herein as N substrate 308. As also shown in FIG. 3 this N substrate 308 may be parallel to the other substrates and may fixed halfway in between the top substrate 313 and the bottom substrate 312. Pillar 307 and substrate 308 also electrically connect the gate and source of the switch S3 to the neutral terminal N.

Column 501 illustrates steps in preparation of the top part 511. In step 1 the top substrate 311 is prepared, by carving the desired electrical paths in the conductive layer(s) of the substrate 311. In step 2, the top secondary part 513 is attached to the substrate 511. This does not necessarily have to be an electrically conductive attachment. Also, the switch S1 is fixed to the top substrate 311, in the shown example by electrically connecting the drain side to the top substrate 311 to provide an electrical connection to the DCP terminal. In step 3 the source of the switch S1 is connected by a wire to the substrate 311 which provides an electrical connection to the AC terminal. Moreover, a gate part 521 provides individual electrical connections of the gates of switches S1 and S2 to their respective gain terminals 523.

Column 502 illustrates steps in preparation of the bottom part 512. In step 1 the bottom substrate 312 is prepared, by carving the desired electrical paths in the conductive layer(s) of the substrate 312. In step 2, the bottom secondary part 514 is attached to the substrate 512. This does not necessarily have to be an electrically conductive attachment. Also, the switch S4 is fixed to the bottom substrate 312, in the shown example by electrically connecting the drain side to the bottom substrate 312 to provide an electrical connection with the AC terminal. In step 3 the source of the switch S4 is connected by a wire to the substrate 312 which provides an electrical connection to the DCN terminal. Moreover, another gate part 522 provides individual electrical connections of the gates of switches S3 and S4 to their respective gain terminals 523. Also the capacitor C2 is connected to the bottom substrate 312. Also the copper posts 301 and 302 are fixed to the bottom substrate 311. In step 4, the N substrate or busbar is attached, with the capacitor C1 on top of it.

Finally, the top part 511 and the bottom part 512 are connected (fixed together with electrical connections as needed) to form the package 300.

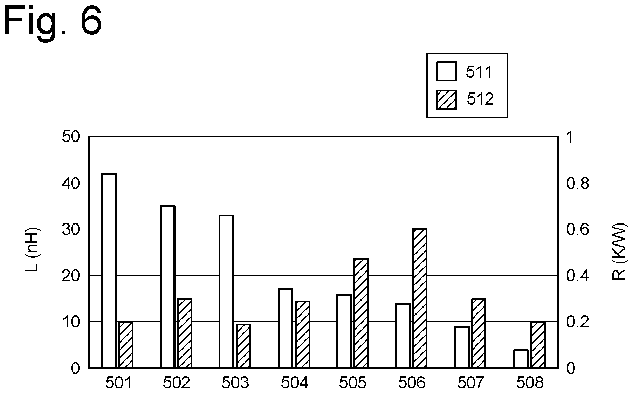

FIG. 6 shows the performance of eight different packages in a test that was performed. Each bar has two parts, showing stray inductance (L) in nanohenry (nH) (left bar part 511) and thermal resistance (R) in Kelvin per Watt (K/W) (right bar part 512). Bar 501 shows performance of Semikron SEMIX 5P 1.2kV 400A. Bar 502 shows performance of Infineon EconoPACK 4 1.2 kV 300A. Bar 503 shows performance of Fuji Electric V series 1.2 kV 300 A. Bar 504 shows performance of Semikron SKIM4 1.2 kV 400A. Bar 505 shows performance of Infineon EconoPACK2 1.2 kV 150 A. Bar 506 shows performance of Infineon EasyPACK 2B 1.2 kV 100A. Bar 507 shows performance of Vincotech MNPC X4 1.2 kV 400A. These names of products currently on the market are trademarks of their respective owners. Bar 508 shows performance of the package 300 disclosed herein. Compared with the shown products currently on the market, the package 300 demonstrates lower stray inductance and lower thermal resistance. The proposed solution resulted in a relatively low stray inductance, around 3.5nH for both the TCL and BCL loops.

Another aspect provides a method of using the power module set forth. The method comprises providing a direct current to the positive direct current terminal, the negative direct current terminal, and the neutral terminal of the power module; providing alternating signals to gate terminals of the switching elements; and optionally cooling the power module using the first cooling element and the second cooling element.

While the present disclosure has been described with reference to exemplary embodiments, it will be understood by those skilled in the art that various changes may be made, and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiments disclosed, but that the present disclosure will include all embodiments falling within the scope of the appended claims.

## Claims

1. A power module comprising
a positive direct current terminal (DCP), a negative direct current terminal (DCN), a neutral terminal (N) and an alternating current terminal (AC), wherein
the positive direct current terminal (DCP) is connected to the alternating current terminal (AC) via a first switching element (S1),
the neutral terminal (N) is connected to the alternating current terminal (AC) via a third switching element (S3) and a second switching element (S2), and
the negative direct current terminal (DCN) is connected to the alternating current terminal (AC) via a fourth switching element (S4);
wherein the power module further comprises a top substrate (311) and a bottom substrate (312) facing the top substrate (311), and wherein at least one of the switching elements (S1, S2, S3, S4) is fixed to the top substrate (311) and at least one of the switching elements (S1, S2, S3, S4) is fixed to the bottom substrate (312).

2. The power module according to claim 1, wherein the power module further comprises a top secondary substrate (313) fixed to the top substrate (311) and a bottom secondary substrate (314) fixed to the bottom substrate (312), wherein the top secondary substrate (313) and the bottom secondary substrate (314) are in between the top substrate (311) and the bottom substrate (312).

3. The power module according to claim 2, wherein
the second switching element (S2) is fixed to the top secondary substrate (313), wherein the top secondary substrate (313) is in between the top substrate (311) and the second switching element (S2), and
the third switching element (S3) is fixed to the bottom secondary substrate (314), wherein the bottom secondary substrate (314) is in between the third switching element (S3) and the bottom substrate (312).

4. The power module according to any preceding claim, wherein the top substrate (311) and the bottom substrate (312) each comprise two conductive surfaces (309a, 309b) with an isolating layer (309c) in between.

5. The power module according to any one of claims 2 to 4, wherein the top secondary substrate (311) and the bottom secondary substrate (312) each comprise two conductive surfaces with an isolating layer in between.

6. The power module according to claim 5 in dependence on claim 4, wherein
the second switching element (S2) is fixed to the top secondary substrate (313), wherein the top secondary substrate (313) is in between the second switching element (S2) and the top substrate (311), and
the third switching element is fixed to the bottom secondary substrate, wherein the bottom secondary substrate is in between the third switching element and the bottom substrate.

7. The power module according to any preceding claim, further comprising a first supportive conductive element (301) connecting the top substrate (311) to the bottom substrate (312) or a second supportive conductive element (302) connecting the top secondary substrate (313) to the bottom secondary substrate (314).

8. The power module according to any preceding claim, wherein a drain side of the first switching element (S1) is fixed to the conductive surface of the top substrate (311), a drain side of the second switching element (S2) is fixed to the conductive surface of the top secondary substrate (313), a drain side of the third switching element (S3) is fixed to the conductive surface of the bottom secondary substrate (314), and a drain side of the fourth switching element (S4) is fixed to the conductive surface of the bottom substrate (312).

9. The power module according to claim 8, wherein a source of the first switching element (S1) is conductively connected to the conductive surface of the top substrate (311), a source of the second switching element (S2) is conductively connected to the conductive surface of the top secondary substrate (313), a source of the third switching element (S3) is conductively connected to the conductive surface of the bottom secondary substrate (312), and a source of the fourth switching element (S4) is conductively connected to the conductive surface of the bottom substrate (312),
wherein the respective conductive surface is interrupted in between the respective drain side and connection to the source of the same switching element, so that the drain and the source of the same switching element are not connected to each other via the conductive surface.

10. The power module according to any preceding claim, wherein the first switching element (S1) faces the fourth switching element (S4) and the second switching element (S2) faces the third switching element (S3).

11. The power module according to claim 10,
comprising a first supportive conductive element (301) connecting the top substrate (311) to the bottom substrate (312),
wherein the second switching element (S2) is fixed in between the first switching element (S1) and the first supportive conductive element (301), and
wherein the third switching element (S3) is fixed in between the fourth switching element (S4) and the first supportive conductive element (301).

12. The power module according to any preceding claim, wherein the first switching element (S1), the second switching element (S2), the third switching element (S3), and the fourth switching element (S4) each comprise a power semiconductor switch.

13. The power module according to any preceding claim, wherein the power module further comprises
a first cooling element (321) adjacent a surface of the top substrate (311) facing away from the bottom substrate (312); and
a second cooling element (322) adjacent a surface of the bottom substrate (312) facing away from the top substrate (311).

14. A method of using the power module of claim 13, comprising
providing a direct current to the positive direct current terminal (DCP), the negative direct current terminal (DCN), and the neutral terminal (N) of the power module; and
providing alternating signals to gate terminals (523) of the switching elements.
